# EUROPÄISCHE PATENTANMELDUNG

(11) **EP 1 865 089 A2**
(43) Veröffentlichungstag der Anmeldung: **12.12.2007**
(21) Anmeldenummer: 07009001.4
(22) Anmeldetag: 03.05.2007
(51) Int. Cl.: C23C 14/24, B21F 21/00

(54) **Verfahren zum Aufdampfen dünner Schichten im Vakuum und Draht zu seiner Ausführung**

(30) Priorität: 06.06.2006 DE 102006026523
(71) Anmelder: Berkenhoff GmbH, 35452 Heuchelheim (DE)
(72) Erfinder: Nöthe, Tobias, 35745 Herborn (DE); Holzapfel, Reiner, 35102 Lohra-Kirchvers (DE)
(74) Vertreter: Tappe, Hartmut

(57) **Zusammenfassung**

Die Erfindung betrifft ein Verfahren zum Aufdampfen dünner Schichten im Vakuum aus einem Verdampfer (13) auf ein Substrat oder Werkstück und einen Draht (12) zu dessen Ausführung, wobei eine Verdampfereinrichtung (16) mittels einer Zuführeinrichtung (11) zumindest ein Draht (12) zugeführt wird, der Draht in die Verdampfereinrichtung vorgeschoben wird und der Draht in der Verdampfereinrichtung geschmolzen und verdampft wird, wobei ein Draht (12) mit einem als Polygon ausgebildeten Querschnittsprofil verwendet wird, welcher im Vergleich zu einem Draht mit einem Kreisquerschnittsprofil eine im Verhältnis zur Querschnittsfläche relativ große Mantelfläche (20) aufweist, sodass eine dem Schmelzpunkt eines Drahtwerkstoffes zumindest angenäherte Temperatur vor Eintritt des Drahtes (12) in eine in der Verdampfereinrichtung gebildete Schmelze im Draht erreicht wird.

## Beschreibung

Die Erfindung betrifft ein Verfahren zum Aufdampfen dünner Schichten im Vakuum auf ein Substrat oder Werkstück, wobei einer Verdampfereinrichtung mittels einer Zuführeinrichtung zumindest ein Draht zugeführt wird, der Draht gegen die Verdampfereinrichtung vorgeschoben wird und der Draht auf der Verdampfereinrichtung geschmolzen und verdampft wird sowie einen Draht zur Ausführung des Verfahrens.

Aus dem Stand der Technik sind insbesondere als Hochvakuum-Bandbedampfung bezeichnete Verfahren bekannt, welche zum Beschichten von flexiblen Substraten oder Werkstücken mit Metallen, wie z. B. Aluminium, Zink oder Kupfer, eingesetzt werden. Bei diesem Verfahren wird das zu beschichtende Substrat kontinuierlich über eine gekühlte Walze geführt und dabei Metalldampf ausgesetzt, der sich auf einer Oberfläche des Substrates als dünne Schicht niederschlägt oder die Werkstücke werden dem Metalldampf ausgesetzt, welcher sich auf deren Oberfläche ebenfalls als dünne Schicht abscheidet. Die Erzeugung eines Dampfstroms erfolgt üblicherweise, indem auf ein sogenanntes Verdampferschiffchen aus Keramik, welcher durch elektrische Widerstandserwärmung erhitzt wird, ein Metalldraht zugeführt wird, sodass dieser sich auf einer Verdampferoberfläche verflüssigt und unter einem vorliegenden Vakuum schließlich verdampft. Durch kontinuierliche Drahtzuführung und entsprechende Anordnung von Verdampferschiffchen können gleichmäßig dicke Schichten auf einem Substrat, z. B. einer dünnen Folie aus Polyester, erzeugt werden. Bei den zum Einsatz kommenden Drähten handelt es sich um Runddrähte, deren Abmessung typischerweise in einem Durchmesserbereich von ein bis zwei Millimeter liegt. Die Wahl des Drahtwerkstoffs richtet sich dabei jeweils nach der geforderten Anwendung. Der einzelne Draht wird mit Hilfe von Zuführrollen von einer Drahtspule abgerollt, durch ein Röhrchen geführt und anschließend schräg auf die Verdampferoberfläche zugeführt. Ziel der Einrichtung ist es, den Draht möglichst an einer konstanten, mittigen Position auf der Oberfläche des Verdampfers auftreffen zu lassen. Um ein hitzebedingtes Verschleißen des Röhrchens zu vermeiden, endet dieses einige Zentimeter vor und oberhalb des Verdampferschiffchens, sodass der Draht eine freie Länge ungeführt zu überwinden hat.

Bei den bekannten Verfahren wird zum Aufschmelzen eines als Runddraht ausgebildeten Drahtes im Verdampferschiffchen Wärmeenergie vorwiegend durch den Draht vermittels konduktiver Temperatureinleitung im Verdampferschiffchen aufgenommen. Somit erfolgt eine Erwärmung des Drahtes bis zu seinem Schmelzpunkt und ein darauffolgendes Aufschmelzen des Drahtes im Wesentlichen in der im Verdampferschiffchen befindlichen Schmelze. Die Folge ist ein zeitlich relativ langer Aufwärm- und Aufschmelzprozess, welcher eine Einleitung größerer Materialmengen begrenzt und somit einer höheren Verdampfungsrate und einer damit verbundenen höheren Durchsatzleistung eines Beschichtungsverfahrens entgegensteht.

Der vorliegenden Erfindung liegt daher die Aufgabe zugrunde, ein Verfahren und einen Draht zur Ausführung des Verfahrens vorzuschlagen, bei dem im Vergleich zu einem Runddraht eine höhere Verdampfungsrate und Durchsatzleistung eines Beschichtungsverfahrens, bei gleicher Wärmeleistung und gleicher zu erzeugender Schichtdicke, ermöglicht wird. Gleichwohl sollen die Anforderungen an den Draht hinsichtlich einer positionsgenauen Zuführung weiter gewährleistet sein.

Diese Aufgabe wird durch ein Verfahren mit den Merkmalen des Anspruchs 1 und einen Draht mit den Merkmalen des Anspruchs 9 gelöst.

Bei dem erfindungsgemäßen Verfahren zum Aufdampfen dünner Schichten im Vakuum auf ein Substrat oder Werkstück, wird einer Verdampfereinrichtung mittels einer Zuführeinrichtung zumindest ein Draht zugeführt, wobei der Draht gegen die Verdampfereinrichtung vorgeschoben wird und der Draht auf der Verdampfereinrichtung geschmolzen und verdampft wird.

Erfindungsgemäß wird ein Draht mit einem Querschnittsprofil verwendet, dessen Kontur aus Bogenteilstücken mit unterschiedlichen Krümmungsradien und/oder Geraden zusammengesetzt ist, und welcher im Vergleich zu einem Draht mit einem Kreisquerschnittsprofil eine im Verhältnis zur Querschnittsfläche relativ große Mantelfläche aufweist, sodass eine dem Schmelzpunkt eines Drahtwerkstoffes zumindest angenäherte Temperatur vor Eintritt des Drahtes in eine in der Verdampfereinrichtung gebildete Schmelze im Draht erreicht wird.

Aufgrund der Erfindung wirkt die vom Verdampfer ausgehende Wärmestrahlung zumindest auf einen dem Verdampfer zugewandten Mantelflächenbereich des Drahtes und es erfolgt eine Temperaturbeaufschlagung des Drahtes mittels Wärmestrahlung. Durch die geometrische Querschnittsform des Drahtes wird der Anteil der Mantelfläche, die einer Wärmestrahlung des Verdampfers bei der Zuführung ausgesetzt wird, gegenüber einem Runddraht relativ vergrößert. Die vom Verdampfer ausgehende Wärmestrahlung wird so in vorteilhafter Weise für die Drahtaufheizung genutzt. Weiter ergibt sich beim Auftreffen des Drahtes auf eine Oberfläche der Schmelze ein, hinsichtlich einer Kontaktfläche, je nachdem in welchem Winkel der Draht der Verdampfereinrichtung zugeführt wird, ein relativ größerer Kontakt im Vergleich zu einem kreisförmigen Kontakt im Falle eines Runddrahtes. Somit wird ein konduktiver Wärmeeintrag in den Draht vergleichsweise erhöht und ein schnelleres Aufschmelzen des Drahtes erreicht. Gleichsam wird durch die vom Kreisquerschnittsprofil abweichende Form des Drahtes eine raschere Verteilung des geschmolzenen Drahtwerkstoffs auf der Oberfläche der Schmelze erreicht, sodass letztlich eine schnellere Verdampfung erfolgen kann. Die Kontur des Drahtes kann beispielsweise harmonisch, etwa Sinuswellenförmig, ausgebildet sein. Es können sich aber auch Bogenteilstücke mit Geraden im Konturverlauf abwechseln.

Als besonders vorteilhaft erweist es sich, insbesondere wegen der einfachen Herstellung des Drahtes, wenn das Querschnittsprofil des Drahtes als Polygon ausgebildet ist.

Als besonders vorteilhaft erweist es sich auch, wenn zur Ausführung des Verfahrens ein Draht mit einem als Vierkant ausgebildeten Querschnittsprofil verwendet wird. Bei einer rechteckigen Ausbildung des Querschnittsprofils des Drahtes kann durch eine geringere Dicke des Querschnittsprofils, im Vergleich zu einem Draht mit einem Kreisquerschnittsprofil, eine geringere Neigung zur Bildung größerer Schmelztropfen erreicht werden, welche durch eventuelle Spritzerbildung die Gleichmäßigkeit einer aufgedampften Materialschicht beeinträchtigen können.

Das Verfahren kann in einer vorteilhaften Variante unter Verwendung eines Drahtes, der aus einem metallischen Werkstoff gebildet ist, ausgeführt werden. Insbesondere Drähte, die im Wesentlichen aus Aluminium, Zink oder Kupfer bestehen, können verwendet werden. Durch den Einsatz metallischer Drähte können Substrate oder Werkstücke mit einer metallischen Oberflächenschicht unter Anwendung des erfindungsgemäßen Verfahrens bedampft werden.

Um sicher zu stellen, dass die zu verdampfende Metallmenge im gleichen Zeitraum mindestens so groß ist wie die aufgeschmolzene Metallmenge, ist es besonders vorteilhaft, wenn bei dem erfindungsgemäßen Verfahren ein Draht mit einem Querschnittsprofil in einem Verhältnis von Profilbreite zu Profildicke von 2 bis 200 zu 1 verwendet wird, wobei die oberste Grenze für die Breite des Drahtes im Wesentlichen der Breite der Verdampfereinrichtung entspricht. Hierdurch ist es möglich, dem Draht die notwendige Biegesteifigkeit zu verleihen, damit der Draht die freie Drahtführungsstrecke ohne wesentliche Verformung oder Verwindung überwinden kann.

Da der Draht üblicherweise etwa in der Mitte der Verdampfereinrichtung auftrifft, kann mit zunehmenden Breitenmaß des Drahtes ein Zugang des Metalldampfes zu einem Substrat abgeschattet werden. Daher kann es je nach Anordnung von Verdampfer und Substrat zueinander vorteilhaft sein, das Verfahren dergestalt auszuführen, dass ein Draht mit einem Querschnittsprofil in einem Verhältnis von Profilbreite zu Profildicke von 5 bis 100 zu 1 verwendet wird und die Breite des Drahtprofils kleiner als die Breite der Verdampfereinrichtung gewählt wird.

In einer vorteilhaften Variante des Verfahrens kann ein Draht zu dessen Ausführung verwendet werden, der mit zumindest einer als Radius ausgebildeten Profilkante eines Querschnittprofils ausgebildet ist. Hierdurch kann in vorteilhafter Weise die Standzeit einer Zuführeinrichtung beeinflusst werden, da die Führungselemente der Zuführeinrichtung nicht durch Kantenabrieb beansprucht werden.

Einen weiteren Vorteil bei der Ausführung des erfindungsgemäßen Verfahrens im Hinblick auf die optimale Nutzung der Wärmestrahlung bietet eine Vergrößerung einer Drahtoberfläche bei gleichbleibender Profilbreite durch Einbringung einer zusätzlichen Oberflächenstruktur. Dies wird bei dem Verfahren insbesondere dadurch erreicht, dass ein Draht verwendet wird, bei dem in zumindest einer Oberfläche zumindest eine, als V-förmige Profilrille im Querschnittsprofil des Drahtes ausgebildete Ausnehmung, ausgebildet ist.

Soll bei dem erfindungsgemäßen Verfahren ein Draht mit einem besonders dünnen Querschnitt verwendet werden, erweist es sich als besonders vorteilhaft, wenn ein Draht verwendet wird, bei dem in zumindest einer Oberfläche zumindest eine, als U-förmige Profilrille im Querschnittsprofil des Drahtes ausgebildete Ausnehmung ausgebildet ist. Eventuelle Kerbwirkungen bei der Handhabung des Drahtes werden so verringert.

Bei einem Draht zur Erzeugung einer Oberflächenbeschichtung, insbesondere auf Substrate oder Werkstücke, durch Aufdampfen dünner Schichten im Vakuum aus einem Verdampfer, wobei einer Verdampfereinrichtung mittels einer Zuführeinrichtung zumindest ein Draht zugeführt wird, der Draht in dem die Verdampfereinrichtung vorgeschoben wird und der Draht in der Verdampfereinrichtung geschmolzen und verdampft wird, erweist es sich als besonders vorteilhaft, wenn ein Querschnittsprofil des Drahtes als Polygon ausgebildet ist.

Weitere vorteilhafte Ausführungsformen eines Drahtes ergeben sich aus den Merkmalsbeschreibungen der auf dem Verfahrensanspruch 1 rückbezogenen Unteransprüche.

Im folgenden wird die Erfindung unter Bezugnahme auf die beigefügte Zeichnung näher erläutert.

Es zeigen:
- Fig. 1:: eine Verfahrensanordnung mit einer Zuführeinrichtung, einem Draht und einer Verdampfereinrichtung in einer Seitenansicht;
- Fig. 2:: die axonometrische Darstellung eines Drahtabschnittes gemäß einer ersten Ausführungsform;
- Fig. 3:: die axonometrische Darstellung eines Drahtabschnittes gemäß einer zweiten Ausführungsform;
- Fig.4:: die axonometrische Darstellung eines Drahtabschnittes gemäß einer dritten Ausführungsform;
- Fig. 5:: die axonometrische Darstellung eines Drahtabschnittes gemäß einer vierten Ausführungsform.

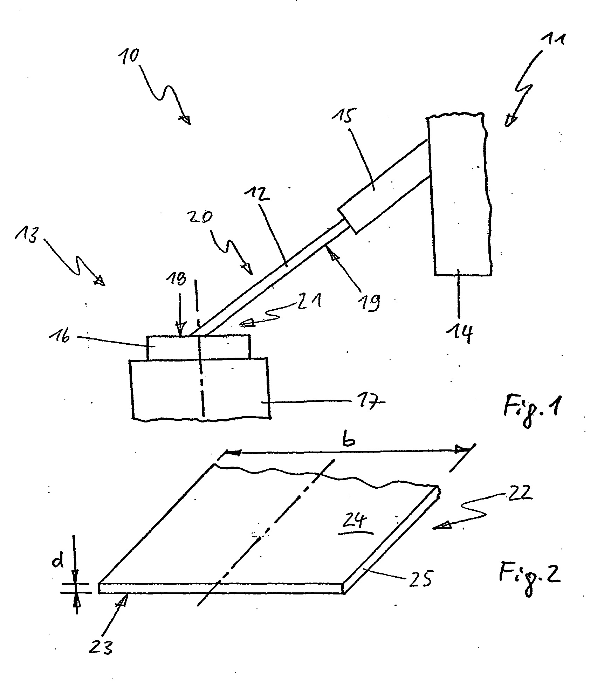

Fig. 1 zeigt ein Ausführungsbeispiel einer Verfahrensanordnung 10 zum Aufdampfen dünner Schichten im Vakuum mit einer Zuführeinrichtung 11, einem Draht 12 und einem Verdampfer 13, wobei auf die Darstellung weiterer zur Durchführung des Verfahrens notwendiger Bauteile, wie eine Vakuumkammer und mögliche Substrate bzw. Werkstücke, verzichtet wurde. Die Zuführeinrichtung 11 weist ein Gehäuse 14 auf, in dem die für eine Vorschubbewegung des Drahtes 12 hier nicht näher dargestellten notwendigen technischen Einrichtungen aufgenommen sind und einen Hohlkörper 15, der nicht näher dargestellte Führungseinrichtungen beinhaltet, die eine Führung des Drahtes 12 zum Verdampfer 13 in geeigneter Weise gewährleisten. Der Verdampfer 13 weist eine Verdampfereinrichtung 16 auf, die in einer Verdampfereinrichtungsaufnahme 17 aufgenommen ist. In einer Oberfläche 18 der Verdampfereinrichtung 16 ist eine nicht näher dargestellte Ausnehmung ausgebildet, die als Reservoir für eine Schmelze dient, in welche der Draht 12 vorgeschoben wird. Der Draht 12 wird bei diesem Vorgang auf einer freien Länge zwischen dem Hohlkörper 15 und der Oberfläche 18 mit vom Verdampfer 13 ausgehender Wärmestrahlung beaufschlagt. Die vom Verdampfer 13 ausgehende Wärmestrahlung wirkt im Wesentlichen auf einen Mantelflächenbereich 19 einer Mantelfläche 20 des Drahtes 12 ein und erwärmt diesen derart, dass in einem Eintrittsbereich 21 eine dem Schmelzpunkt eines Drahtwerkstoffes zumindest angenäherte Temperatur vor Eintritt des Drahtes 12 in die in der Verdampfereinrichtung 16 befindliche Schmelze im Draht 12 erreicht wird.

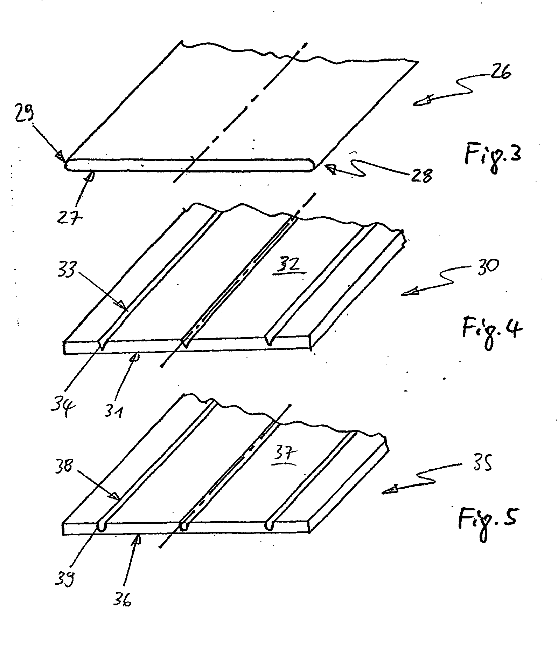

Ein in Fig. 2 in einem Abschnitt dargestellter Draht 22 ist als Draht mit einem Rechteckprofil 23 ausgebildet. Eine Breite b des Rechteckprofils 23 ist dabei relativ groß im Vergleich zu einer Dicke d, derart, dass eine Oberfläche 24 gegenüber einer Seitenfläche 25 relativ groß ist.

Fig. 3 zeigt eine Ausführungsform eines Drahtes 26, der als Rechteckprofil 27 ausgebildet ist und dessen Profilkanten 28 mit einem Radius 29 ausgebildet sind.

Fig. 4 zeigt einen Draht 30, der als Rechteckprofil 31 ausgebildet ist und in dessen Oberfläche 32 eine Mehrzahl von Ausnehmungen 33 als V-förmige Profilrille 34 in Längsrichtung des Drahtes 30 ausgebildet sind.

Fig. 5 zeigt einen Draht 35, der als Rechteckprofil 36 ausgebildet ist und in dessen Oberfläche 37 eine Mehrzahl von Ausnehmungen 38 als U-förmige Profilrille 39 in Längsrichtung des Drahtes 35 ausgebildet sind.

## Patentansprüche

1. Verfahren zum Aufdampfen dünner Schichten im Vakuum auf ein Substrat oder Werkstück, wobei einer Verdampfereinrichtung (16) mittels einer Zuführeinrichtung (11) zumindest ein Draht (12, 22, 26, 30, 35) zugeführt wird, der Draht gegen die Verdampfereinrichtung vorgeschoben wird und der Draht auf der Verdampfereinrichtung geschmolzen und verdampft wird,
**dadurch gekennzeichnet,**
**dass** ein Draht (12, 22, 26, 30, 35) mit einem Querschnittsprofil verwendet wird, dessen Kontur aus Bogenteilstücken mit unterschiedlichen Krümmungsradien und/oder Geraden zusammengesetzt ist, und welcher im Vergleich zu einem Draht mit einem Kreisquerschnittsprofil eine im Verhältnis zur Querschnittsfläche relativ große Mantelfläche (20) aufweist, sodass eine dem Schmelzpunkt eines Drahtwerkstoffes zumindest angenäherte Temperatur vor Eintritt des Drahtes (12, 22, 26, 30, 35) in eine in der Verdampfereinrichtung gebildete Schmelze im Draht erreicht wird.

2. Verfahren nach Anspruch 1,
**dadurch gekennzeichnet,**
**dass** ein Draht (12, 22, 26, 30, 35) mit einem als Polygon ausgebildeten Querschnittsprofil verwendet wird.

3. Verfahren nach Anspruch 1 oder 2,
**dadurch gekennzeichnet,**
**dass** ein Draht (12, 22, 26, 30, 35) mit einem als Vierkant ausgebildeten Querschnittsprofil verwendet wird.

4. Verfahren nach einem der vorangehenden Ansprüche,
**dadurch gekennzeichnet,**
**dass** ein Draht (12, 22, 26, 30, 35) aus einem metallischen Werkstoff verwendet wird.

5. Verfahren nach einem der Ansprüche 3 oder 4,
**dadurch gekennzeichnet,**
**dass** ein Draht (12, 22, 26, 30, 35) mit einem Querschnittsprofil in einem Verhältnis von Profilbreite zu Profildicke von 2 bis 200 zu 1 verwendet wird.

6. Verfahren nach einem der Ansprüche 3 oder 4,
**dadurch gekennzeichnet,**
**dass** ein Draht (12, 22, 26, 30, 35) mit einem Querschnittsprofil in einem Verhältnis von Profilbreite zu Profildicke von 5 bis 100 zu 1 verwendet wird.

7. Verfahren nach einem der vorangehenden Ansprüche,
**dadurch gekennzeichnet,**
**dass** ein Draht (12, 22, 26, 30, 35) mit zumindest einer als Radius (29) ausgebildeten Profilkante (28) des Querschnittsprofils verwendet wird.

8. Verfahren nach einem der vorangehenden Ansprüche,
**dadurch gekennzeichnet,**
**dass** ein Draht (12, 22, 26, 30, 35) verwendet wird, bei dem in zumindest einer Oberfläche (32, 37) zumindest eine, als V-förmige Profilrille (34) im Querschnittsprofil des Drahtes ausgebildete Ausnehmung (33, 38) ausgebildet ist.

9. Verfahren nach einem der Ansprüche 1 bis 8,
**dadurch gekennzeichnet,**
**dass** ein Draht (12, 22, 26, 30, 35) verwendet wird, bei dem in zumindest einer Oberfläche (32, 37) zumindest eine, als U-förmige Profilrille (39) im Querschnittsprofil des Drahtes ausgebildete Ausnehmung (33, 38) ausgebildet ist.

10. Draht zur Erzeugung einer Oberflächenbeschichtung, insbesondere auf Substrate oder Werkstücke, durch Aufdampfen dünner Schichten im Vakuum aus einem Verdampfer (13), wobei einem Verdampfertiegel (16) mittels einer Zuführeinrichtung (11) zumindest ein Draht (12, 22, 26, 30, 35) zugeführt wird, der Draht in die Verdampfereinrichtung vorgeschoben wird und der Draht in der Verdampfereinrichtung geschmolzen und verdampft wird,
**dadurch gekennzeichnet,**
**dass** ein Querschnittsprofil des Drahtes (12, 22, 26, 30, 35) als Polygon ausgebildet ist.

11. Draht nach Anspruch 10,
**dadurch gekennzeichnet,**
**dass** ein Querschnittsprofil des Drahtes (12, 22, 26, 30, 35) als Vierkant ausgebildet ist.

12. Draht nach einem der Ansprüche 10 oder 11,
**dadurch gekennzeichnet,**
**dass** der Draht (12, 22, 26, 30, 35) aus einem metallischen Werkstoff gebildet ist.

13. Draht nach einem der Ansprüche 11 oder 12,
**dadurch gekennzeichnet,**
**dass** das Querschnittsprofil des Drahtes (12, 22, 26, 30, 35) in einem Verhältnis von Profilbreite zu Profildicke von 2 bis 200 zu 1 ausgebildet ist.

14. Draht nach einem der Ansprüche 11 oder 12,
**dadurch gekennzeichnet,**
**dass** das Querschnittsprofil des Drahtes (12, 22, 26, 30, 35) in einem Verhältnis von Profilbreite zu Profildicke von 5 bis 100 zu 1 ausgebildet ist.

15. Draht nach einem der Ansprüche 10 bis 14,
**dadurch gekennzeichnet,**
**dass** zumindest eine Profilkante des Querschnittsprofils des Drahtes (12, 22, 26, 30, 35) als Radius (29) ausgebildet ist.

16. Draht nach einem der Ansprüche 10 bis 15,
**dadurch gekennzeichnet,**
**dass** zumindest in einer Oberfläche (32, 37) des Drahtes (12, 22, 26, 30, 35) zumindest eine, als V-förmige Profilrille (34) im Querschnittsprofil des Drahtes ausgebildete Ausnehmung (33, 38), ausgebildet ist.

17. Draht nach einem der Ansprüche 10 bis 16,
**dadurch gekennzeichnet,**
**dass** zumindest in einer Oberfläche (32, 37) des Drahtes (12, 22, 26, 30, 35) zumindest eine, als U-förmige Profilrille (39) im Querschnittsprofil des Drahtes ausgebildete Ausnehmung(33, 38), ausgebildet ist.
